(19) Europäisches Patentamt
European Patent Office
Office européen des brevets

(11) Veröffentlichungsnummer : **0 571 899 B1**

(12) # EUROPÄISCHE PATENTSCHRIFT

(45) Veröffentlichungstag der Patentschrift : **02.11.94 Patentblatt 94/44**

(51) Int. Cl.[5] : **G03F 7/037,** G03F 7/027

(21) Anmeldenummer : **93108257.2**

(22) Anmeldetag : **21.05.93**

(54) **Durch Einwirkung von Strahlung vernetzendes Gemisch und dessen Verwendung zur Herstellung hochtemperaturbeständiger Reliefstrukturen.**

(30) Priorität : **29.05.92 DE 4217688**

(43) Veröffentlichungstag der Anmeldung : **01.12.93 Patentblatt 93/48**

(45) Bekanntmachung des Hinweises auf die Patenterteilung : **02.11.94 Patentblatt 94/44**

(84) Benannte Vertragsstaaten : **AT BE CH DE ES FR GB IT LI NL**

(56) Entgegenhaltungen :
**EP-A- 0 119 719**
**EP-A- 0 380 010**
**EP-A- 0 430 221**

(73) Patentinhaber : **BASF Lacke + Farben Aktiengesellschaft**
**Postfach 61 23**
**D-48136 Münster (DE)**

(72) Erfinder : **Haehnle, Hans-Joachim, Dr.**
**Prager Strasse 27**
**W-6700 Ludwigshafen (DE)**
Erfinder : **Schwarz, Manfred**
**Huehnenkamp 1f**
**W-2000 Hamburg-Schenefeld (DE)**
Erfinder : **Blum, Rainer**
**Bannwasserstrasse 58**
**W-6700 Ludwigshafen (DE)**

(74) Vertreter : **Springer, Hans Jörg, Dr.**
**BASF Aktiengesellschaft,**
**Patentabteilung ZDX - C 6**
**D-67056 Ludwigshafen (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 571 899 B1

Jouve, 18, rue Saint-Denis, 75001 PARIS

## Beschreibung

Die Erfindung betrifft durch Einwirkung von Strahlung vernetzende Gemische, die lösliche polymere Vorstufen hochtemperaturbeständiger heterocyclischer Polymerer, copolymerisierbare ethylenisch ungesättigte Verbindungen, Photoinitiatoren, Lösungsmittel sowie gegebenenfalls weitere Hilfs- oder Zusatzstoffe enthalten, sowie deren Verwendung zur Herstellung hochtemperaturbeständiger Reliefstrukturen, wobei unter hochtemperaturbeständigen heterocyclischen Polymeren insbesondere Polyimide, Polyisoindolochinazolindione und Polyaroylenbenzimidazole zu verstehen sind, deren Vorstufen noch freie Carboxylgruppen tragen.

Es ist bekannt, hochwärmebeständige Reliefstrukturen insbesondere für den Aufbau elektronischer Schaltungen zu erzeugen, indem zunächst lösliche, strahlungsempfindliche, bevorzugt UV-empfindliche Vorstufen A aus Lösung auf ein Substrat aufgetragen und unter milden Bedingungen getrocknet werden, dann unter einer Maske mit Strahlung einer geeigneten Wellenlänge eine vernetzte Zwischenstufe B gebildet wird, mit geeigneten Lösemittelgemischen sodann die nicht bestrahlten, d.h. unbelichteten Stellen, die noch die Vorstufe A enthalten, ausgewaschen werden und die so erzeugten Reliefstrukturen anschließend unter Anwendung hoher Temperatur (Ausheizschritt) in die Endfunktionsstruktur der Stufe C überführt werden.

Für die Erzeugung solcher Reliefstrukturen, die z.B. als Interlayerdielektrika oder als Passivierungsschichten für Mikrochips Verwendung finden, werden wegen der hohen thermischen und mechanischen Belastungen bei der Herstellung als Stoffe der Funktionsstufe C bevorzugt die oben erwähnten heterocyclischen bzw. aromatisch/heterocyclischen Polymeren verwendet.

Die löslichen Vorstufen A für solche Polymeren C sind im allgemeinen Verbindungen von polyamidischer Grundstruktur, und zwar so, daß in Ortho- bzw. Peristellung zur Amidgruppe eine andere Gruppe steht, in der Regel eine Carboxyl- oder Estergruppe, die bei der Überführung in die Stufe C unter Anwendung höherer Temperaturen, mit der Amidgruppe eine Kondensationsreaktion eingeht.

Ein Weg, polymere, polyamidische Grundstrukturen der Stufe A strahlenvernetzbar zu machen, ist die Einführung ungesättigter Seitengruppen, wie an einem Polyamidsäureester verdeutlicht wird:

2x

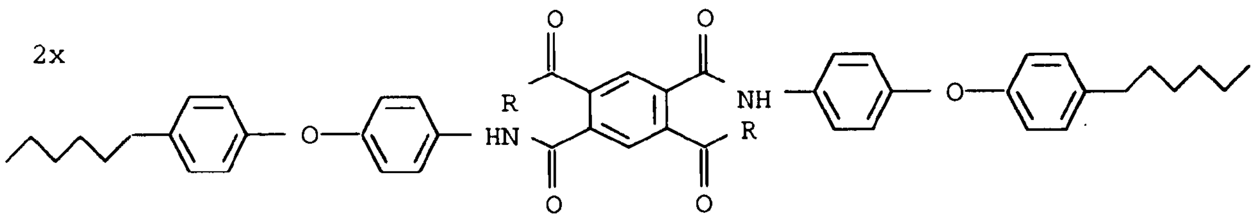

Strahlungsempfindliche Vorstufe A

R ist ein eine ethylenisch ungesättigte Gruppierung enthaltender Rest

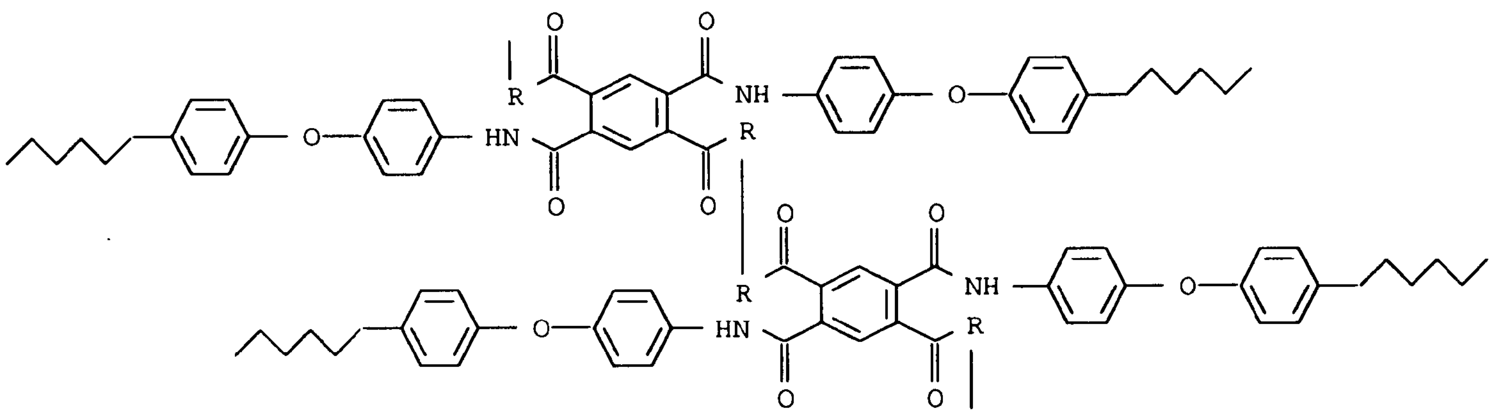

Strahlungsvernetzte Zwischenstufe B

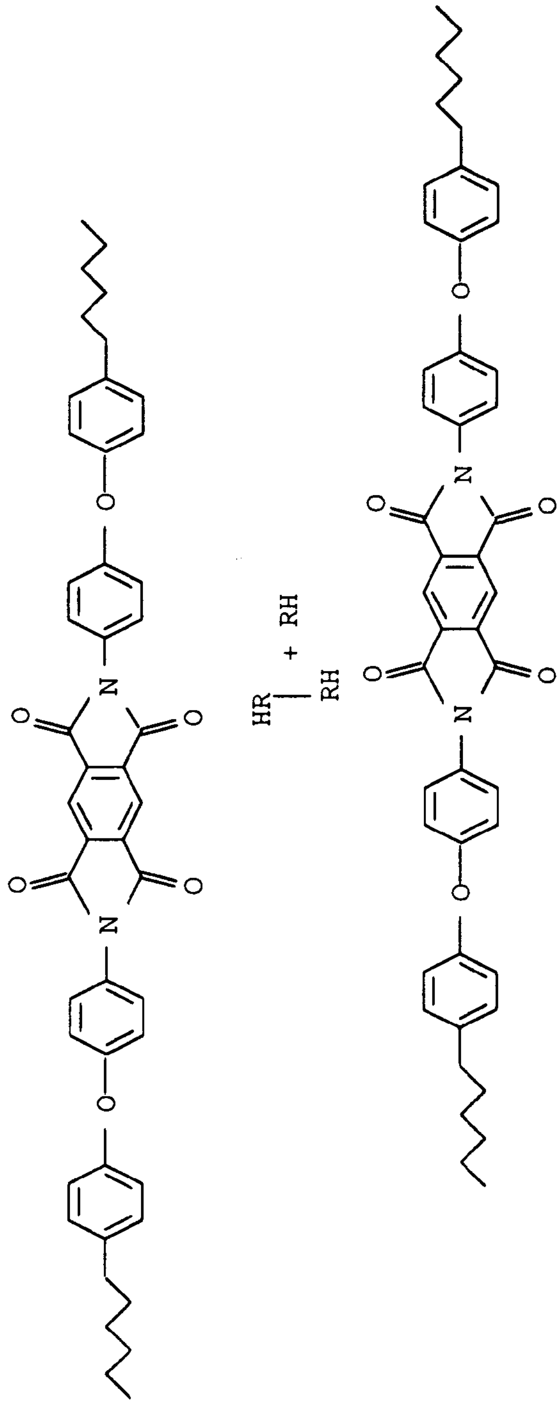

Endfunktionsstruktur C

Die Einführung ungesättigter Gruppen in polymere Vorstufen A ist beispielsweise beschrieben in DE-A-2 437 397, DE-A-2 437 348, DE-A-2 437 413, DE-A-2 437 369, DE-A-2 919 840, DE-A-2 919 841, DE-A-2 933 826 und DE-A-2 308 830.

Im allgemeinen werden folgende drei Wege zum Aufbau lichtempfindlicher Vorstufen A nach dem Stand der Technik benutzt:

a) Die Einführung der lichtempfindlichen Gruppen, in der Regel ethylenisch ungesättigte Gruppen, in die Monomerbausteine und danach Aufbau der höhermolekularen Vorstufen.

Ein typisches Beispiel für diesen Weg wird in DE-A-2 437 397 angegeben, nämlich die Addition von Allylalkohol an Pyromellithsäureanhydrid, Umsetzung des entstandenen Halbesters mit Thionylchlorid zum Säurechlorid und aus diesem Aufbau der Polymeren durch Umsetzung mit aromatischen Diaminen.

Weitere Schriften zum Stand der Technik, die Aufbauwege von ungesättigten monomeren Bausteinen ausgehend beschreiben, sind z.B. DE-A-2 437 369, DE-A-2 437 413, DE-A-2 919 840, DE-A-2 919 841, DE-A-3 411 660, DE-A-3 411 697, DE-A-3 411 706, DE-A-3 411 714, US-A 4 551 522 und US-A 4 558 117.

b) Ein anderer Weg zur Einführung lichtempfindlicher ungesättigter Gruppen besteht darin, zunächst polymere bzw. oligomere Produkte ohne lichtempfindliche Gruppen aufzubauen und in diese dann lichtempfindliche Gruppen einzuführen.

Ein typisches Beispiel für diesen Weg wird z.B. in DE-A-2 933 826 beschrieben. Hier werden Pyromellithsäureanhydrid und Diaminodiphenyloxid in Dimethylacetamid als Lösemittel zu einem Polyamid addiert, das Carboxylgruppen enthält. An diesen Carboxylgruppen werden dann mit Glycidylmethacrylat Doppelbindungen eingeführt, wodurch die Vorprodukte A gebildet werden, die in Gegenwart von Photoinitiatoren unter UV-Licht vernetzbar sind.

Prinzipielle Nachteile des Standes der Technik nach Weg a) sind die aufwendige Reaktionssequenz und die Schwierigkeiten beim Aufbau der polymeren Stufen A, die sich aus dem ungesättigten Charakter der Ausgangs- und der Endstoffe ergeben.

Ebenso ist es schwierig nach Weg b) in polymere Produkte nachträglich Doppelbindungen einzuführen. Hier dürfen z.B. nur relativ niedrige Temperaturen angewandt werden, was lange Reaktionszeiten und schlechte Umsätze ergibt. Weiter müssen trotzdem z.T. Polymerisationsinhibitoren bei der Herstellung zugegeben und später in aufwendigen Reinigungsschritten wieder entfernt werden, um bei der Verwendung eine hohe Lichtempfindlichkeit zu erreichen.

Eine Reihe der oben genannten Patentschriften betrifft deshalb auch nicht das Prinzip, sondern Optimierungen der Methoden zur Herstellung der polymeren, lichtempfindlichen Vorstufen. Trotzdem bleibt ihre Herstellung kritisch.

c) Um diesen Problemen auszuweichen, wird in anderen Patentschriften vorgeschlagen, zunächst wie beim Weg b) ebenfalls nicht lichtempfindliche Polyamidsäuren aufzubauen und diese nachträglich durch einfache Zugabe ungesättigter Amine, die mit den Polyamidsäuren Salze bilden (vgl. z.B. DE-A-2 914 619), sehr schonend lichtempfindlich zu machen.

Hauptprobleme bei diesem Weg sind die schlechte Löslichkeit der Polymersalze und ihre hohe Viskosität, so daß nur Lösungen mit geringen Feststoffgehalten hergestellt werden können. Schließlich weisen die nach c) hergestellten Vorstufen bei Raumtemperatur eine für die Verarbeitung nur unzureichende Lagerstabilität auf.

Ein weiteres grundsätzliches Problem betrifft den Ausheizschritt der nach a) oder b) hergestellten Vorstufen A. Da die ungesättigten Gruppen kovalent an die Vorstufen der Heterocyclenpolymeren gebunden sind, müssen für längere Zeiten hohe Temperaturen angewendet werden, um eine quantitative Cyclisierung zu erreichen. Dabei färben sich die erzeugten Reliefstrukturen nicht nur schwarz, sondern die gewünschten mechanischen Eigenschaften, wie Biege- und Knickfestigkeit werden nicht erreicht. Gerade diesen Eigenschaften kommen durch den Trend in der Mikroelektronik zu immer größeren und immer höher integrierteren chips eine immer größere Bedeutung zu, um die gewünschte Zuverlässigkeit der erzeugten Bauteile sicherzustellen und um die Fehlerquote bei der Herstellung zu minimieren.

Aufgabe der vorliegenden Erfindung ist es, Photoresiste auf der Basis von löslichen Vorstufen von z.B. Polyimid, Polyisoindolochinazolindion, Polyaroylenbenzimidazol oder anderen Polyheterocyclen bereitzustellen, die die oben genannten Nachteile vermeiden, d.h., einfach und reproduzierbar herzustellen sind und Reliefstrukturen mit der gewünschten Biege- und Knickfestigkeit liefern.

Diese Aufgabe läßt sich überraschenderweise sehr vorteilhaft durch die erfindungsgemäßen Gemische lösen.

Gegenstand der vorliegenden Erfindung sind durch Einwirkung von Strahlung vernetzende Gemische, die dadurch gekennzeichnet sind, daß sie im wesentlichen bestehen aus

(I) mindestens einer in polaren organischen Lösungsmitteln löslichen carboxylgruppenhaltigen polymeren Vorstufe hochtemperaturbeständiger heterocyclischer Polymerer,

(II) mindestens einem copolymerisierbaren ethylenisch ungesättigten ternären Sulfoniumsalz,

(III) mindestens einem Photoinitiator oder Photoinitiatorsystem und

(IV) mindestens einem polaren aprotischen organischen Lösungsmittel.

Bevorzugt als Komponente (I) sind Polyamidsäuren der allgemeinen Struktur

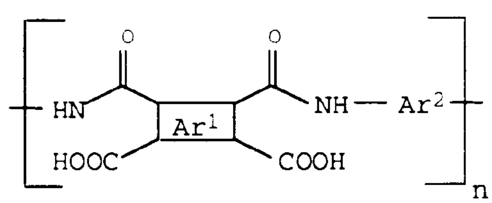

wobei die Carboxylgruppen an $Ar^1$ so gebunden sind, daß sie ortho- oder peri-ständig zu den Amidogruppen stehen,
$Ar^1$ ein substituierter oder nicht substituierter 4-wertiger aromatischer, araliphatischer, alicyclischer, aliphatischer oder heterocyclischer Rest ist,
$Ar^2$ ein substituierter oder nicht substituierter 2-wertiger, aromatischer, araliphatischer, alicyclischer, aliphatischer oder heterocyclischer Rest ist. Die Polyamidsäure kann ein statistisches Copolymer oder ein Blockcopolymer sein, wobei mindestens 2 unterschiedliche Gruppen $Ar^1$ und/oder $Ar^2$ in der Polyamidsäure enthalten sein können.

Als Komponente (II) sind Umsetzungsprodukte aus Thiodiglykol mit Glycidyl(meth)acrylat und einer organischen Mono-, Di- oder Polycarbonsäure bevorzugt.

Bevorzugte Ausführungsformen der erfindungsgemäßen Gemische bestehen auch darin, daß als Komponente (II) ein ternäres Sulfoniumsalz eingesetzt wird, das sowohl im Kation als auch im Anion jeweils mindestens eine ethylenisch ungesättigte Gruppe enthält, bzw. daß es sich bei den in der Komponente (II) enthaltenen ethylenisch ungesättigten Gruppen um Acrylat- oder Methacrylatgruppen handelt.

Als Komponente (III) bevorzugt sind Azide.

Die erfindungsgemäßen Gemische können zusätzlich sogenannte "Reaktivverdünner", d.h., von Komponente (II) verschiedene ethylenisch ungesättigte copolymerisierbare organische Verbindungen sowie gegebenenfalls weitere Hilfs- oder Zusatzstoffe, wie Verlaufshilfsmittel, Sensibilisatoren und/oder Haftvermittler enthalten.

Gegenstand der vorliegenden Erfindung ist auch ein Verfahren zur Herstellung von hochtemperaturbeständigen Reliefstrukturen durch bildmäßige Bestrahlung von auf einem Träger angebrachten Schichten strahlungsempfindlicher Gemische und Entfernung der unbestrahlten Bereiche dieser Schichten, das dadurch gekennzeichnet ist, daß die Schichten strahlungsempfindlicher Gemische aus erfindungsgemäßen Gemischen bestehen.

Zu den Aufbaukomponenten der erfindungsgemäßen Gemische sowie zum erfindungsgemäßen Verfahren zur Herstellung hochtemperaturbeständiger Reliefstrukturen ist im einzelnen folgendes auszuführen.

Das erfindungsgemäße Gemisch enthält als Komponente (I) in polaren aprotischen organischen Lösungsmitteln lösliche carborylgruppenhaltige polymere Vorstufen hochtemperaturbeständiger heterocyclischer Polymerer.

Vorstufen derartiger Polyheterocyclen werden im allgemeinen erhalten durch Umsetzung von aromatischen, heterocyclischen oder cycloaliphatischen Dianhydriden der allgemeinen Formel $O(CO)_2R(CO)_2O$ mit, gegebenenfalls substituierten, Polyaminen.

Als Beispiele für geeignete Dianhydride, ohne Einschränkung auf diese, können genannt werden die Dianhydride der Pyromellithsäure
oder der
Benzol-1,2,3,4-tetracarbonsäure,
Dianhydride der
4,4-Veresterungs-, 4,4-Veretherungs- und 4,4-Amidisierungsdimere der Trimellithsäure,
Dianhydride der
3,3′,4,4′-Biphenyltetracarbonsäure,
2,2′,4,4′-Biphenyltetracarbonsäure,
2,3,3′,4′-Biphenyltetracarbonsäure,
3,3′,4,4′-Benzophenontetracarbonsäure,
2,2′,3,3′-Benzophenontetracarbonsäure,
2,3,3′,4′-Benzophenontetracarbonsäure,
2,3,6,7-Naphthalintetracarbonsäure,
1,2,5,6-Naphthalintetracarbonsäure,
1,2,4,5-Naphthalintetracarbonsäure,
1,4,5,8-Naphthalintetracarbonsäure,
1,2,6,7-Naphthalintetracarbonsäure,
2,6-Dichlornaphthalin-1,4,5,8-tetracarbonsäure,
2,7-Dichlornaphthalin-1,4,5,8-tetracarbonsäure,
2,3,6,7-Tetrachlornaphthalin-1,4,5,8-tetracarbonsäure,
1,4,5,8-Tetrachlornaphthalin-2,3,6,7-tetracarbonsäure,
4,8-Dimethyl-1,2,3,5,6,7-hexahydronaphthalin-1,2,5,6-tetracarbonsäure,
4,8-Dimethyl-1,2,3,5,6,7-hexahydronaphthalin-2,3,6,7-tetracarbonsäure,
4,4′-Oxydiphthalsäure,
3,3′-Oxydiphthalsäure,

4,4′-Sulfonyldiphthalsäure,
4,4′-Sulfonyldiphthalsäure,
4,4′-Thiodiphthalsäure,
3,3′-Thiodiphthalsäure,
4,4′-Acetylidendiphthalsäure,
Bis(2,3-dicarboxyphenyl)methan,
Bis(3,4-dicarboxyphenyl)methan,
1,1-Bis(2,3-dicarboxyphenyl)ethan,
1,1-Bis(3,4-dicarboxyphenyl)ethan,
2,2-Bis(2,3-dicarboxyphenyl)propan,
2,2-Bis(3,4-dicarboxyphenyl)propan,
Phenanthren-1,2,7,9-tetracarbonsäure,
Phenanthren-1,2,6,7-tetracarbonsäure,
Phenanthren-3,4,5,6-tetracarbonsäure,
Phenanthren-1,2,9,10-tetracarbonsäure,
2,3,9,10-Perylentetracarbonsäure,
3,4,9,10-Perylentetracarbonsäure,
2,3,8,9-Perylentetracarbonsäure,
4,5,10,11-Perylentetracarbonsäure,
4,5,11,12-Perylentetracarbonsäure,
3,3″,4,4″-Terphenyltetracarbonsäure,
2,2″,3,3″-p-Terphenyltetracarbonsäure,
2,3,3″,4″-p-Terphenyltetracarbonsäure,
Butan-1,2,3,4-tetracarbonsäure,
Cyclopentan-1,2,3,4-tetracarbonsäure,
Pyrrolidin-2,3,4,5-tetracarbonsäure,
Thiophen-2,3,4,5-tetracarbonsäure,
Pyrazin-2,3,5,6-tetracarbonsäure, Tetrahydrofurantetracarbonsäure,
9-Brom-10-merkaptoanthracentetracarbonsäure,
2,6-Endovinylencyklohexan-1,2,4,5-tetracarbonsäure,
die einzeln oder als Gemisch für die Synthese der Vorstufe der Polyheterocyclen eingesetzt werden können.

Unter Polyamine werden aromatische, araliphatische, heterocyclische, cycloaliphatische, aliphatische Verbindungen vom folgenden Typ verstanden:

$$S_nR(NH_2)_m$$

$0 \le n \le m$, $1 < m$, wobei n und m ganze Zahlen sind
R = aromatischer, araliphatischer, heterocyclischer, cycloaliphatische, aliphatischer Rest
S = OH, COOH, $NH_2$, $CONH_2$, $CSNH_2$.

Als Beispiele für geeignete Polyamine, ohne Einschränkung auf diese, können genannt werden:

p-Phenylendiamin,
m-Phenylendiamin,
4,4′-Diaminodiphenyloxid,
3,3′-Diaminodiphenyloxid,
3,4′-Diaminodiphenyloxid,
4,4′-Diaminodiphenylsulfid,
3,3′-Diaminodiphenylsulfid,
3,4′-Diaminodiphenylsulfid,
4,4′-Diaminodiphenylsulfon,
3,3′-Diaminodiphenylsulfon,
3,4′-Diaminodiphenylsulfon,
4,4′-Diaminodiphenylmethan,
3,3′-Diaminodiphenylmethan,
3,4′-Diaminodiphenylmethan,
(4,4′-Diaminodiphenyl)-propan,
(3,3′-Diaminodiphenyl)-propan,
(4,4′-Diaminodiphenyl)-ethan,
(3,3′-Diaminodiphenyl)-ethan,
4,4′-Bis (4,4′-aminophenoxy)-biphenyl,
4,4′-Bis (4,3′-aminophenoxy)-biphenyl,

2,2-Bis[4-(4,4-aminophenoxy)phenyl]-propan,
2,2-Bis[4-(4,4-aminophenoxy)phenyl]-perfluorpropan,
2,2-Bis[4-(3,4-aminophenoxy)phenyl]-propan,
2,2-Bis[4-(3,3′-aminophenoxy)phenyl]-propan,
2,2-Bis[4-(4,4′-aminophenoxy)phenyl]-sulfon,
2,2-Bis[4-(3,4-aminophenoxy)phenyl]-sulfon,
2,2-Bis[4-(3,3′-aminophenoxy)phenyl]-sulfon,
4,4′-Dimethyl-3,3′-diaminodiphenylsulfon,
2,2-Bis[4-(4,4′-aminophenoxy)phenyl]-sulfid,
2,2-Bis[4-(3,4-aminophenoxy)phenyl]-sulfid,
2,2-Bis[4-(3,3′-aminophenoxy)phenyl]-sulfid,
2,2-Bis[4-(4,4′-aminophenoxy)phenyl]-methan,
2,2-Bis[4-(3,4-aminophenoxy)phenyl]-methan,
2,2-Bis[4-(3,3′-aminophenoxy)phenyl]-methan,
1,4-Bis-(4,4′-aminophenoxy)-phenylen,
1,4-Bis-(3,4′-aminophenoxy)-phenylen,
1,4-Bis-(3,3′-aminophenoxy)-phenylen,
4,4′-Diaminobenzanilid,
3,4′-Diaminobenzanilid,
3,3′-Diaminobenzanilid,
4,4′-Diaminodiphenyl (Benzidin),
3,4′-Diaminodiphenyl,
3,3′-Diaminodiphenyl,
3,3′-Dimethoxy-4,4′-diaminodiphenyl,
3,3′-Dimethoxy-3,4′-diaminodiphenyl,
3,3′-Dimethyl-4,4′-diaminodiphenyl,
3,3′-Dimethyl-3,4′-diaminodiphenyl,
1,8-Diaminonaphthalin,
1,5-Diaminonaphthalin,
p-Terphenyl-4,4″-diamin,
p-Terphenyl-3,3″-diamin,
5-tert.-Butyl-2,4-toluylendiamin,
3-tert.-Butyl-2,6-toluylendiamin,
3,5-Diethyl-2,4-toluylendiamin,
3,5-Diethyl-2,6-toluylendiamin,
α,ω-Diamino-(polyphenylensulfid)e,
m-Xylylendiamin,
p-Xylylendiamin,
Bis-4,4′-[(2,6-diisopropyl)aminophenyl]methan,
Bis-4,4′-[(2-methyl-6-isopropyl)aminophenyl]methan,
Bis-4,4′-[(2,6-dimethyl)aminophenyl]methan,
Bis-4,4′-[(2,6-diisopropyl)aminophenyl]ether,
Bis-4,4′-[(2-methyl-6-isopropyl)aminophenyl]ether,
Bis-4,4′-[(2,6-dimethyl)aminophenyl]ether,
Diamino-(dimethyl-)-dicyclohexyl-methan,
Diamino-(dimethyl-diisopropyl-)-dicyclohexyl-methan,
Diamino-(tetraisopropyl-)-dicyclohexyl-methan,
Diamino-(diisopropyl-)-dicyclohexyl-methan,
Diisopropyltoluylendiamin,
Alkyliso-propyl-toluylendiamin,
3,3′,4,4′-Tetraaminobiphenyl,
3,3′,4,4′-Tetraaminodiphenylmethan,
3,3′,4,4′-Tetraaminodiphenylether,
3,3′,4,4′-Tetraaminodiphenylsulfon,
3,3′,4,4′-Tetraaminodiphenylsulfid,
3,3′-Dihydrorybenzidin,
Hexafluoro-2,2-bis-(4-hydroxy-3-aminophenyl)-propan,
Methylenbisanthranilsäure,

2,4-Diaminobenzoesäure,
Methylenbisanthranilsäurebisamid sowie
2,4-Diaminobenzoesäureamid.

Unter Polyaminen im Sinne der Erfindung sollen auch Verbindungen verstanden werden, die das Strukturelement N-N enthalten, d.h., Derivate des Hydrazins darstellen.

Bei der Herstellung der Vorstufen der Polyheterocyclen kann vorteilhaft mit Zusatz von Reglern gearbeitet werden. Dadurch ist es möglich, gezielt Festgehalt und Viskosität der Vorstufen einzustellen, wobei gleichzeitig die Reproduzierbarkeit verbessert wird.

Ohne Regler werden hochmolekulare und damit hochviskose Lösungen erhalten, die nur noch schwer zu verarbeiten sind.

Ferner verbessert der Zusatz von Reglern, sofern es sich um ethylenisch ungesättigte Verbindungen handelt, die Lichtempfindlichkeit der aus diesen Vorstufen hergestellten Resiste, da die Regler als Endgruppen in die Polyheterocyclenvorstufen eingebaut werden. Als Beispiel sind die Strukturformeln geregelter Polyamidsäuren aufgeführt.

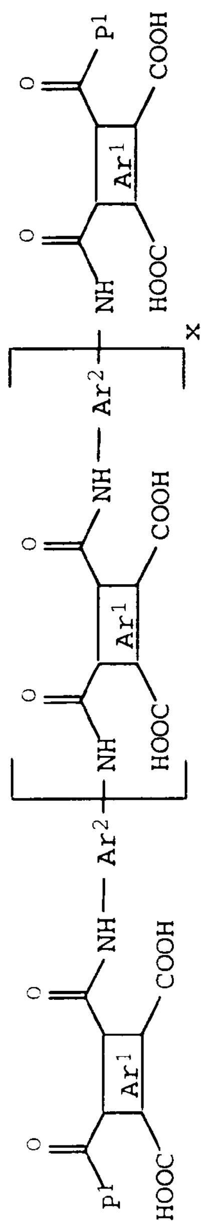

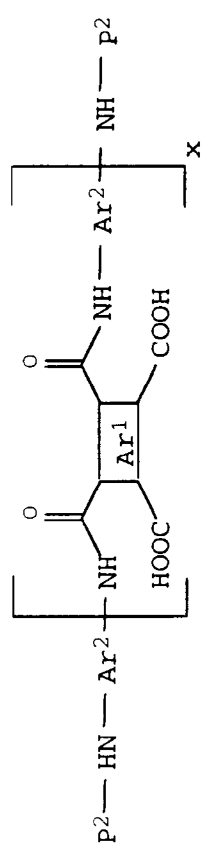

$P^1$ = -O-$R^1$, -NH-$R^1$

$P^2$ = -CO-$R^1$, -CO-NH-$R^1$, -CO-O$R^1$.

$R^1$ = aliphatischer, cycloaliphatischer, araliphatischer, aromatischer oder heterocyclischer Rest, der vorzugsweise eine polymerisierbare Mehrfachbindung enthält.

Geregelt wird in der Weise, daß vor oder während der Herstellung der Polyheterocyclenvorstufe ein Teil der Dianhydrids und/oder des Polyamins mit der Reglerkomponente umgesetzt werden, so daß im Sinne des Polymeraufbaus monofunktionelle Polymerbausteine erhalten werden, die als Endgruppen in der Polymerkette wirken.

Als Regler für die Dianhydride können Monohydroxy- bzw. Monoaminoverbindungen eingesetzt werden, vorzugsweise solche, die ungesättigte Gruppen tragen, z.B.
2-Hydroxyethylacrylat,
2-Hydroxyethylmethacrylat,
Glyzerindiacrylat,
Glyzerindimethacrylat,
3-Hydroxypropylacrylat,
3-Hydroxypropylmethacrylat,
2-Hydroxypropylacrylat,
2-Hydroxypropylmethacrylat,
4-Hydroxybutylacrylat,
4-Hydroxybutylmethacrylat,
Polyethylenglycolmodifiziertes Acrylat,
Polypropylenglycolmodifiziertes Acrylat,
Polyethylenglycolmodifiziertes Methacrylat,
Polypropylenglycolmodifiziertes Methacrylat,
Pentaerythrittriacrylat,
Pentaerythrittrimethacrylat,
Dipentaerythritpentaacrylat,
Dipentaerythritpentamethacrylat, Trimethylolpropandiacrylat,
Trimethylolpropandimethacrylat,
Zimtalkohol,
Allylalkohol,
Pentaerythrittriallylether,
Trimethylolpropandiallylether,
4-Hydroxybutylallylether,
Glyzerindiallylether,
Allylamin,
Diallylamin sowie
4-Aminostyrol.

Als Regler für die Polyamine können Monoanhydride bzw. Monoisocyanate eingesetzt werden, vorzugsweise solche, die ungesättigte Gruppen tragen, z.B.:
Maleinsäureanhydrid,
Itaconsäureanhydrid,
Methacrylsäureanhydrid,
Acrylsäureanhydrid,
Isocyanatoethylmethacrylat,
1-(1-Isocyanato-1-methylethyl)-4-(1-methylethenyl)-benzol, Monoadditionsprodukte von ungesättigten Alkoholen an 2,4-Toluylendiisocyanat sowie
Monoadditionsprodukte von ungesättigten Alkoholen an 2,4'-Isocyanatodiphenylmethan.

Bezüglich der miteinander zur Reaktion zu bringenden Ausgangskomponenten sowie der Reaktionsbedingungen ist zu erwähnen, daß zweckmäßigerweise bei Temperaturen zwischen -10 und +100°C in hochpolaren organischen Lösungsmitteln gearbeitet wird.

Komponente (I) ist im erfindungsgemäßen Gemisch im allgemeinen in einer Menge von 5 bis 60, vorzugsweise 20 bis 45 Gew.-%, bezogen auf das gesamte Gemisch enthalten.

Als Komponente (II) enthält das erfindungsgemäße Gemisch copolymerisierbare ethylenisch ungesättigte ternäre Sulfoniumsalze.

Ternäre Sulfoniumsalze sind Umsetzungsprodukte von Thioethern mit Epoxiden in Gegenwart einer Säure oder von Thioethern mit anderen Alkylierungsmitteln, wie Alkylhalogeniden, Alkylsulfaten usw. Maßgeblich ist, daß mindestens eine der verwendeten Komponenten eine ungesättigte, polymerisierbare Mehrfachbindung enthält, so daß das erhaltene Sulfoniumsalz mindestens eine ungesättigte, polymerisierbare Mehrfachbindung enthält, entweder im Sulfoniumteil oder aber im Gegenion.

$$\begin{array}{c} R''' \\ | \\ R'-S^{+}-R'' \\ X^{-} \end{array}$$

| | |
|---|---|
| R′, R″, R‴ | = aliphatische, aromatische, araliphatische oder cycloaliphatische Reste, möglicherweise unterbrochen durch O, N, S, Carbonylgruppe, Ester oder Amidbindung und gegebenenfalls substituiert durch OH, |
| $X^-$ | = organisches oder anorganisches Anion, dessen Nukleophilie so gering ist, daß es bei Raumtemperatur nicht mit der Sulfoniumgruppe reagiert. |

Besonders bevorzugt sind die Umsetzungsprodukte von gesättigten oder ungesättigten Thioethern mit ungesättigten Epoxiden wie z.B. Glycidylmethacrylat oder Glycidylacrylat in Gegenwart einer Säure oder die Umsetzungsprodukte von ungesättigten Thioethern mit gesättigten Epoxiden in Gegenwart einer Säure.

Bevorzugt sind solche Umsetzungen, bei denen die Thioether hydroxysubstituiert sind, z.B. das Sulfoniumsalz der allgemeinen Formel

$$HO-CH_2-CH_2-\underset{\displaystyle R}{\overset{+}{S}}-CH_2-CH_2-OH \qquad X^-$$

worin R eine ethylenisch ungesättigte Gruppe enthält und $X^-$ für ein organisches oder anorganisches Säureanion steht.

Weiterhin bevorzugt sind die Umsetzungen, bei denen die eingesetzte Säure zusätzlich zum Epoxid oder Thioether eine polymerisierbare Mehrfachbindung trägt, wie z.B. Crotonsäure, Methacrylsäure, Acrylsäure, Fumarsäure, Zimtsäure, Maleinsäure, Propiolsäure, 2-Acrylamidoglycolsäure, 2,2-Bis(acrylamido)essigsäure, allgemein die Additionsprodukte von ungesättigten Alkoholen oder Aminen (wie sie oben bereits als Regler aufgelistet wurden) an Mono- oder Polyanhydride z.B. 4-(2-Methacryloyloxyethyl)maleinsäure, 4-(2-Acryloyloxyethyl)maleinsäure, Phthalsäuremonomethacryloyloxyethylester, Phthalsäuremonoacryloyloxyethylester, Pyromellithsäuredi-(2-methacryloyloxyethylester), N,N-Diallylmaleinsäuremonoamid sowie N,N-Diallylitaconsäuremonoamid.

Ganz besonders bevorzugt sind Umsetzungsprodukte von Thiodiglycol mit ungesättigten Epoxiden und den oben genannten ungesättigten Säuren.

Komponente (II) ist im erfindungsgemäßen Gemisch im allgemeinen in einer Menge von 1 bis 50, vorzugsweise 10 bis 35 Gew.-%, bezogen auf das gesamte Gemisch enthalten.

Als Komponente (III) enthält das erfindungsgemäße Gemisch einen Photoinitiator oder ein Photoinitiatorsystem.

Als Photoinitiatoren kommen praktisch alle bekannten Systeme z.B. H-abstrahierende Systeme, $\alpha$-Spalter und besonders bevorzugt Azide in Frage. Als Beispiele sind zu nennen:

Benzophenon,
Acetophenon,
Benzanthron,
Anthrone,
4,4′-N,N,N′,N′-Tetramethyldiaminobenzophenon (Michlers Keton),
Phenanthrene,
2-Nitrofluoren,
Nitroacenaphthen, Benzochinon,
N-Acetyl-p-nitroanilin,
p-Nitroanilin,
2-Ethylanthrachinon,
2-tert.Butylanthrachinon,
N-Acetyl-4-nitro-1-naphthylamin,
Picramide,
1,2-Benzanthrachinon,
3-Methyl-1,3-diaza-1,9-benzanthron,
4,4′-Tetraethyldiaminobenzophenon,
2-Chloro-4-nitroanilin,
Dibenzalaceton,

1,2-Naphthochinon,
2,5-Bis-(4′-diethylaminobenzal)-cyclopentan,
2,6-Bis-(4′-diethylaminobenzal)-cyclohexanon,
2,6-Bis-(4′-diethylaminobenzal)-methylcyclohexanon,
2,6-Bis-(4′-dimethylaminobenzal)-methylcyclohexanon,
4,4′-Bis-(dimethylamino)chalcone,
4,4′-Bis-(diethylamino)chalcone,
p-Dimethylaminobenzylidenindanon,
1,3-Bis-(4′-dimethylaminobenzal)-aceton,
1,3-Bis-(4′-diethylaminobenzal)-aceton,
N-Phenyldiethanolamin,
N-p-tolyldiethylamin,
Styrolderivate,
Cumarinderivate,
2,2-Dimethoxy-2-phenylacetophenon,
1-Hydroxycyclohexylphenylketon,
2-Methyl[(4-methylthio)-phenyl]-2-morpholino-1-propan,
3,3′,4,4′-Tetra(tert.-butylperoxycarbonyl)benzophenon,
Benzoin-isopropylether,
Benzoin-isobutylether,
4,4′-Dimethoxybenzil,
1,4-Dibenzoylbenzol,
4-Benzoylbiphenyl,
2-Benzoylnaphthalin,
Methyl-o-benzoyl-benzoat,
2,2′-Bis(o-chlorophenyl)-4,4′,5,5′-tetraphenyl-1,2-bisimidazol,
10-Butyl-2-chloroacridon,
Etyhl-4-dimethylaminobenzoat,
Dibenzoylmethan,
2,4-Diethylthioxanthon,
3,3-Dimethyl-4-methoxybenzophenon,
2-Hydroxy-2-methyl-1-phenylpropan-1-on,
1-(4-Isopropylphenyl)-2-hydroxy-2-methylpropan-1-on,
1-(4-Dodecylphenyl)-2-hydroxy-2-methylpropan-1-on,
1-Phenyl-1,2-butandion-2-(o-methoxycarbonyl)oxim,
1-Phenylpropandion-2-(benzoyl)oxim,
1,2-Diphenylethandion-1-(o-benzoyl)oxim,
1-Phenyl-3-ethoxypropantrion-2-(o-benzoyl)oxim,
Glyzin-Derivate,
Oxazolon-Derivate,
substituierte Hexaarylbisimidazole,
1,3,5-Triazin-2-(4-methoxyphenyl)4,6-di-(trichloromethyl),
1,3,5-Triazin-2-(piperonyl)-4,6-di-(trichloromethyl),
1,3,5-Triazin-2-(4-methoxynaphthalin)-4,6-di-(trichloromethyl) sowie vorzugsweise
Azide, deren $N_3$-Gruppen direkt oder über eine $So_2$- oder CO-Gruppe an einen aromatischen Ring gebunden sind, z.B.
2-(N,N-Dimethylamino)-ethyl-4-azidocinnamat,
2-(N,N-Dimethylamino)-ethyl-4-azidonaphthylketon,
2-(N,N-Dimethylamino)-ethyl-4-azidobenzoat,
5-Azido-1-naphthyl-2′-(N,N-dimethylamino)ethylsulfon,
N-(4-Sulfonylazidophenyl)maleinimid,
N-Acetyl-4-sulfonylazidoanilin,
4-Sulfonylazidoanilin,
4-Azidoanilin,
4-Azidophenacylbromid,
p-Azidobenzoesäure,
2,6-Bis(p-azidobenzyliden)cyclohexanon und
2,6-Bis(p-azidobenzyliden)-4-methylcyclohexanon.

Auch Gemische von Aziden mit nicht Azidogruppen enthaltenden Photoinitiatoren kommen hier in Frage.

Komponente (III) ist im erfindungsgemäßen Gemisch in Mengen von 0,01 bis 10, vorzugsweise 0,5 bis 5 Gew.-%, enthalten.

Als Komponente (IV) werden erfindungsgemäß polare aprotische organische Lösungsmittel eingesetzt.

Auch die Herstellung der oben genannten Vorstufen von Polyheterocyclen (I) erfolgt in der Regel in hochpolaren, vorzugsweise aprotischen Lösemitteln. Als Beispiele für derartige Lösungsmittel können genannt werden:

Formamid, Acetamid, N-Methylformamid, N,N-Dimethylformamid, N,N-Diethylformamid, N-Methylpyrrolidon, N,N-Dimethylacetamid, N,N-Diethylacetamid, γ-Butyrolacton, Caprolactam, Pyrrolidon, Dimethylsulfoxid, Sulfolan, Dimethylsulfon, Hexamethylenphosphorsäureamid, Dimethylpropylenharnstoff, Dimethylethylenharnstoff u.a., wobei N-Methylpyrrolidon, Dimethylacetamid, γ-Butyrolacton und Dimethylsulfoxid bevorzugt sind.

Diese polaren Stoffe können teilweise durch weitere Lösemittel wie Alkohole, Ester, Ketone, Ether und Kohlenwasserstoffe ersetzt werden.

Komponente (IV) kann im erfindungsgemäßen Gemisch im allgemeinen in Mengen von 10 bis 80, vorzugsweise 40 bis 60 Gew.-% enthalten sein.

Das erfindungsgemäße Gemisch kann zusätzlich von Komponente (II) verschiedene ethylenisch ungesättigte copolymerisierbare organische Verbindungen, sogenannte Reaktivverdünner, enthalten.

Reaktivverdünner sind in der Regel niedrigviskose, einfach oder mehrfach ethylenisch ungesättigte Verbindungen, die zur Erhöhung der Lichtempfindlichkeit und zur besseren Verarbeitbarkeit zugesetzt werden. Bevorzugt werden dafür Verbindungen aus der Klasse der Acrylate und Methacrylate sowie deren polyfunktionelle Vertreter.

Besonders geeignet sind:

Hydroxyalkyl-(meth)-acrylate, wie Hydroxyethylacrylat, Hydroxyethylmethacrylat, Hydroxypropylacrylat, Hydroxypropylmethacrylat, Butandiolmonoacrylat, Butandiolmonomethacrylat, N-Hydroxymethylacrylamid, N-Hydroxymethylmethacrylamid, Diethylenglykolmonoacrylat, Diethylenglykolmonomethacrylat, Glyzerindimethacrylat, Glyzerindiacrylat, Glyzerintrimethacrylat, Glyzerintriacrylat, Trimethylolpropandimethacrylat, Trimethylolpropandiacrylat, Trimethylolpropantrimethacrylat, Trimethylolpropantriacrylat, Pentaerythrittrimethacrylat, Pentaerythrittriacrylat, Diaceton(meth)acrylamid, Zimtalkohol, Hydroxyalkylzimtsäureester und Hydroxyzimtalkohol oder Mischungen der genannten Verbindungen.

Weiterhin sind ganz besonders geeignet Amidverbindungen mit Kohlenstoff-Kohlenstoff-Doppelbindungen wie

N-Acrylolyl-piperidin, N-Acrylolylmorpholin, Acrylamid, Methacrylamid,
N-Methylacrylamid, N-Methylmethacrylamid, N-Ethylacrylamid, N-Ethylmethacrylamid, Acrylamidoglykolsäure und weitere N-Alkylacrylamide, N,N-Dimethylacrylamid, N,N-Dimethyl-methacrylamid, N,N-Diethylacrylamid, N,N-Diethylmethacrylamid, weitere N,N-Dialkyl-(meth)-acrylamide, N,N-Dimethylaminoethyl-(meth)-acrylamid, N,N-Dimetyhl-aminopropyl(meth)acrylamid und weitere N-Amino-alkyl-(meth)acrylamide und N,N-Diaminoalkyl(meth)acrylamide, N-Aminoalkoxyalkyl(meth)acrylamide und N,N-Diaminoalkoxyalkyl-(meth)acrylamide sowie N-Vinyl-pyrrolidon.

Besonders geeignet sind weiter die Methylolierungsprodukte von Acryl- und Methacrylamid und deren etherartigen Kondensationsprodukte mit mono- oder polyfunktionellen Alkoholen.

Diese Reaktivverdünner können dem erfindungsgemäßen Gemisch in Mengen von bis zu 25 Gew.-%, bezogen auf die Gesamtmenge, zugesetzt werden.

Den erfindungsgemäßen Gemischen können noch weitere Hilfs- bzw. Zusatzstoffe in geringen Mengen von bis zu 10 Gew.-% zugefügt werden, um bestimmte gewünschte Effekte zu erzielen.

Als weitere derartige Hilfs- bzw. Zusatzstoffe können Verwendung finden:

a) Verlaufshilfsmittel, die dazu dienen, glatte, kraterfreie Oberflächen zu erhalten

b) Sensibilisatoren,

die die Lichtemfpindlichkeit durch Erweiterung des Absorptionsbereichs des eingesetzten Photoinitiators durch wirksame Übertragung von Strahlungsenergie auf den Photoinitiator verbessern, z.B.

Anthrachinon, 2-Methylanthrachinon, 2-Ethylanthrachinon. Benzochinon, 1,2-Naphthochinon, 1,4-Naphthochinon, 1,2-Benzanthrachinon, Benzophenon, 4,4′-Dimethylbenzophenon, Michler's Keton, 2-Nitrofluoren, 5-Nitroacetonaphthen, 4-Nitro-1-naphthylamin, Anthron, 1,9-Benzanthron, Dibenzalaceton, 4,4′-Bis(diethylamino)benzophenon, Acridin, Cyanoacridin, Nitropyren, 1,8-Dinitropyren, Pyren-1,6-chinon, 2-Brom-benzanthrachinon, 9-Fluorenon, 2-Chlor-1,8-phthaloylnaphthalin, usw.

c) Leukofarbstoffe, z.B. Leukokristallviolett;

d) Haftvermittler, z.B. 3-Azidopropyltriethoxysilan.

Verwendung finden die erfindungsgemäßen Mischungen als Photoresiste für die Herstellung hochtemperaturbeständiger Reliefstrukturen, wie sie bei der Herstellung mikroelektronischer Bauteile als Isolations- oder Passivierungsschichten oder auch als α-Partikelbarrieren eingesetzt werden.

Das erfindungsgemäße Verfahren zur Herstellung von Photoresisten sowie die Herstellung von hochtemperaturbeständigen Reliefstrukturen daraus kann in allgemein üblicher Weise durchgeführt werden.

Die besonderen Vorteile der erfindungsgemäßen Gemische und deren Weiterverarbeitung liegen in ihrer einfachen und gut reproduzierbaren Herstellung sowie in der Biege- und Knickfestigkeit der daraus hergestellten Reliefstrukturen.

Die in den Beispielen angegebenen Teile und Prozente sind, soweit nicht anders angegeben, Gewichtsteile bzw. Gewichtsprozente.

Abkürzungen

| | |
|---|---|
| PMDA | Pyromellithsäuredianhydrid |
| BPDA | 3,3′,4,4′-Benzophenontetracarbonsäuredianhydrid |
| ODPA | 4,4′-Oxydiphthalsäureanhydrid |
| BAPP | 2,2-(Bis(4-(4-aminophenoxy)phenyl)propan |
| DADO | 4,4′-Diaminodiphenyloxid |
| NMP | N-Methylpyrrolidon |
| DMAA | Dimethylacetamid |
| DMAP | 4-Dimethylaminopyridin |
| HEA | Hydroxyethylacrylat |
| HEMA | Hydroxyethylmethacrylat |
| GDMA | Glyzerindimethacrylat |
| TDG | Thiodiglycol |
| GMA | Glycidylmethacrylat |
| GA | Glycidylacrylat |
| HQME | Hydrochinonmonomethylether |
| LKV | Leukokristallviolett |
| MAZ | N-(4-Azidosulfonylphenyl)maleinimid. |

A Herstellung der Vorstufen (I)

(I)1:

In einer trockenen Apparatur wurde unter Reinststickstoff 54,5 g PMDA in 130,5 g DMAA bei 70°C gelöst, 0,4 g DMAP zugegeben und innerhalb von 2 Stunden eine Lösung von 102,6 g BAPP in 185,0 g NMP und 54,5 g DMAA bei 70°C zugegeben. Nach Ende der Zugabe wurde noch 2 Stunden bei 70°C gerührt und die erhaltene viskose Lösung auf Raumtemperatur abgekühlt.

Viskosität/Festgehalt: 11000 mPas/30 %

Säurezahl: 53,3 (Theorie 53,5)

(I)2:

In einer trockenen Apparatur wurde unter Reinststickstoff 8,18 g PMDA in 195,2 g DMAA bei 30°C vorgelegt. Es wurden 2,0 g HEA zugegeben und die Mischung 2 Stunden bei 30°C gerührt, dann wurde bei 30°C innerhalb von 2 Stunden eine Lösung von 153,9 g BAPP und 0,6 g DMAP in 277,2 g NMP und 81,9 g DMAA zugegeben und 1 Stunde bei 30°C gerührt. Anschließend wurde die viskose Lösung für 2 Stunden auf 70°C erwärmt.

Viskosität/Festgehalt: 4000 mPas/30 %

Säurezahl: 53,4 (Theorie: 53,5)

(I)3:

Es wurde wie bei (I)2 verfahren, nur wurden 4,1 g HEA verwendet.

Viskosität/Festgehalt: 1600 mPas/30 %

Säurezahl: 53,5 (Theorie: 53,5)

(I)4:

Es wurde wie bei (I)3 verfahren, nur wurden 10,6 g HEA verwendet.

Viskosität/Festgehalt: 630 mPas/30 %

Säurezahl: 53,6 (Theorie: 53,5)

(I)5:

Es wurde wie bei (I)1 verfahren, nur wurden anstelle PMDA 80,6 g BPDA eingesetzt.

Viskosität/Festgehalt: 14000 mPas/30 %

Säurezahl: 45,6 (Theorie: 45,8)

(I)6:

Es wurde wie bei (I)1 verfahren, nur wurden anstelle PMDA 77,6 g ODPA eingesetzt.
Viskosität/Festgehalt: 15000 mPas/30 %
Säurezahl: 46,3 (Theorie: 46,6)

B Herstellung der Sulfoniumsalze (II)

(II)1:

279,4 g TDG, 184,6 g GMA, 0,18 g HQME und 60 g Essigsäure wurden bei Raumtemperatur gemischt und anschließend für 8 Stunden auf 40°C erwärmt. Danach war der Umsatz bezüglich der Essigsäure quantitativ (potentiometrische Titration mit Tetrabutylammoniumhydroxid) . Die Ausbeute an Sulfoniumacetat betrug 75 % (potentiometrische Titration mit Perchlorsäure).

(II)2 bis (II)8:

Wie bei (II)1 beschrieben, wurden von verschiedenen Säuren ausgehend die folgenden Sulfoniumsalze hergestellt:

| Bezeichnung | Säure | Temperatur/ Reaktionszeit | Umsatz Säure | Ausbeute an Sulfoniumsalz |
|---|---|---|---|---|
| (II)2 | Maleinsäure | 40°C/5 h | 100 % | 98 % |
| (II)3 | Oxalsäure | 20°C/4 h | 96 % | 95 % |
| (II)4 | Propargylsäure | 20°C/6 h | 97 % | 81 % |
| (II)5 | Methansulfonsäure | 20°C/1 h | 97 % | nicht bestimmt |
| (II)6 | Crotonsäure | 40°C/9 h | 97 % | 71 % |
| (II)7 | Zimtsäure | 40°C/6 h | 90 % | 67 % |
| (II)8 | 4-(2-Methacryloyloxyethyl)-maleinsäure | 40°C/7 h | 100 % | 93 % |

Beispiele 1 bis 16

Aus den gemäß (I)1 bis (I)6 hergestellten Vorstufen von Polyheterocyclen wurden durch einfaches Zumischen unterschiedlicher Mengen der gemäß (II)1 bis (II)8 erhaltenen Sulfoniumverbindungen und durch die Zugabe von jeweils 5 % MAZ (bezogen auf den Gesamtfeststoffgehalt des Photoresists) und 1 % LKV Photoresistlösungen hergestellt.

Die Photoresistlösungen wurden auf Silicium-Wafer in einer Schichtdicke von 6 µm (trocken) aufgeschleuert, 10 min. bei 80°C auf einer hotplate getrocknet und anschließend mit einer 360 W Quecksilberhochdrucklampe durch eine Graukeilmaske mit 15 Abstufungen (Multidensity Resolution Target der Firma Optoline) für die Dauer von 60 sec belichtet. Danach wurde der Wafer in einem Sprühentwickler 60 sec lang mit N,N'-Dimethylpropylenharnstoff entwickelt und anschließend mit Isopropanol gespült.

Zur Prüfung der mechanischen Eigenschaften wurden Filme der Photoresiste auf Blechstreifen gerakelt, bei 90°C für 30 min unter $N_2$ getrocknet und vollflächig belichtet. Anschließend wurden die Filme in einem Plattentrockenschrank unter Vakuum mit einer Heizrate von 3°/min auf 400°C erhitzt und 30 min bei dieser Temperatur belassen. Nach dem langsamen Abkühlen wurde die Biege- und Knickfestigkeit geprüft.

Biegefestigkeit:

Dazu wurden die Blechstreifen über einen unsymmetrischen Dorn (Länge 200 mm, Durchmesser zwischen 37 mm und 3 mm) um 180° gebogen. Bewertet wurde nach folgender Skala:

1: Der Film reißt an keiner Stelle.
2: Der Film reißt max. bis zur halben Breite des Dorns.
3: Der Film reißt mehr als bis zur halben Breite des Dorns.
4: Der Film reißt auf der gesamten Dornbreite.

Knickfestigkeit:

Sie wurde an abgelösten Filmstreifen geprüft und nach folgender Skala bewertet:
1: Der Film bricht bei mehrfachem Knicken nicht.
2: Der Film bricht erst bei mehrfachem Knicken.
3: Der Film bricht beim Knicken.
4: Der Film ist spröde und bricht schon im Ansatz zum Knicken.
Die Prüfergebnisse sind in der Tabelle angeführt.

Vergleichsbeispiel

109,0 g PMDA und 130,1 g HEMA wurden zusammen mit 400 g γ-Butyrolacton und 100 g Pyridin 40 Stunden bei Raumtemperatur gerührt. Zu der erhaltenen Lösung wurde bei 20°C eine Lösung von 100,1 g DADO und 206 g Dicyclohexylcarbodiimid in 400 g NMP zugetropft. Die Reaktionsmischung wurde über Nacht gerührt. Danach wurde der ausgefallene Dicyclohexylharnstoff abfiltriert. Die erhaltene Lösung wurde in Ethanol ausgefällt, der ausgefallene Polyamidsäureester abgesaugt und im Vakuum getrocknet. Es wurde eine 30%ige Lösung in NMP hergestellt und daraus durch Zugabe von 5 % MAZ und 1 % LKV ein Resist formuliert, der in der gleichen Weise geprüft wurde, wie die oben beschriebenen erfindungsgemäßen Resiste.

Tabelle

| Beispiel Nr. | Vorstufe | Sulfonium-salz/ Menge *) | Grau-keil-stufe**) | Biege-festig-keit | Knick-festig-keit |
|---|---|---|---|---|---|
| 1 | (I)1 | (II)2/100 | 18 | 2 | 3 |
| 2 | (I)1 | (II)3/100 | 14 | 2 | 2 |
| 3 | (I)1 | (II)3/ 75 | 12 | 1 | 1 |
| 4 | (I)1 | (II)3/ 65 | 14 | 1 | 1 |
| 5 | (I)1 | (II)3/ 50 | 24 | 1 | 1 |
| 6 | (I)1 | (II)4 /70 | 22 | 2 | 2 |
| 7 | (I)1 | (II)5/ 70 | 16 | 1 | 1 |
| 8 | (I)1 | (II)6/ 75 | 25 | 1 | 2 |
| 9 | (I)1 | (II)7/ 70 | 22 | 1 | 1 |
| 10 | (I)1 | (II)8/ 75 | 25 | 1 | 2 |
| 11 | (I)1 | (II)2/ 70 | 20 | 2 | 2 |
| 12 | (I)2 | (II)3 9/70 | 18 | 1 | 1 |
| 13 | (I)3 | (II)3 9/70 | 22 | 1 | 1 |
| 14 | (I)4 | (II)3 9/70 | 25 | 1 | 2 |
| 16 | (I)5 | (II)3 9/70 | 14 | 1 | 1 |
| 16 | (I)6 | (II)3 9/70 | 14 | 1 | 1 |
| Vgl.Bsp. | | - | 10 | 4 | 4 |

*) die Menge in Gew.-% bezogen auf den Feststoffgehalt der eingesetzten Vorstufe (I)

**) angegeben ist die Transmission der Graukeilstufe in %; d.h. je kleiner die Zahl, desto höher die Empfindlichkeit.

## Patentansprüche

1. Durch Einwirkung von Strahlung vernetzendes Gemisch, das im wesentlichen besteht aus
   (I) mindestens einer in polaren organischen Lösungsmitteln löslichen carboxylgruppenhaltigen polymeren Vorstufe hochtemperaturbeständiger heterocyclischer Polymerer,
   (II) mindestens einem copolymerisierbaren ethylenisch ungesättigten ternären Sulfoniumsalz,
   (III) mindestens einem Photoinitiator oder Photoinitiatorsystem und
   (IV) mindestens einem polaren aprotischen organischen Lösungsmittel.

2. Gemisch nach Anspruch 1, dadurch gekennzeichnet, daß es als Komponente (I) eine Polyamidsäure der allgemeinen Struktur

   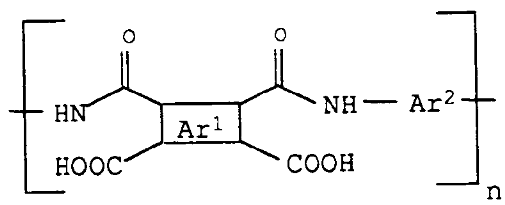

   enthält, wobei die Carboxylgruppen an $Ar^1$ so gebunden sind, daß sie ortho- oder peri-ständig zu den Amidogruppen stehen,
   $Ar^1$ ein substituierter oder nicht substituierter 4-wertiger aromatischer, araliphatischer, alicyclischer, aliphatischer oder heterocyclischer Rest ist,
   $Ar^2$ ein substituierter oder nicht substituierter 2-wertiger aromatischer, araliphatischer, alicyclischer, aliphatischer oder heterocyclischer Rest ist.

3. Gemisch nach Anspruch 2, dadurch gekennzeichnet, daß die Polyamidsäure ein statistisches Copolymer oder Blockcopolymeres darstellt, wobei mindestens 2 unterschiedliche Gruppen $Ar^1$ und/oder $Ar^2$ in der Polyamidsäure enthalten sind.

4. Gemisch nach einem der vorhergehenden Ansprüche, dadurch gekennzeichnet, daß als Komponente (I) Polyamidsäuren eingesetzt werden, die ethylenisch ungesättigte Endgruppen tragen.

5. Gemisch nach einem der vorhergehenden Ansprüche, dadurch gekennzeichnet, daß es als Komponente (II) ein Umsetzungsprodukt aus Thiodiglykol mit Glycidyl(meth)acrylat und einer organischen Mono-, Di- oder Polycarbonsäure enthält.

6. Gemisch nach einem der vorhergehenden Ansprüche, dadurch gekennzeichnet, daß als Komponente (II) ein ternäres Sulfoniumsalz eingesetzt wird, das sowohl im Anion als auch im Kation jeweils mindestens eine ethylenisch ungesättigte Gruppe enthält.

7. Gemisch nach einem der vorhergehenden Ansprüche, dadurch gekennzeichnet, daß es sich bei den in der Komponente (II) enthaltenen ethylenisch ungesättigten Gruppen um Acrylat- oder Methacrylatgruppen handelt.

8. Gemisch nach einem der vorhergehenden Ansprüche, dadurch gekennzeichnet, daß als Komponente (III) ein Azid eingesetzt wird.

9. Gemisch nach Anspruch 8, dadurch gekennzeichnet, daß als Komponente (III) Azide eingesetzt werden, die über eine $SO_2$- oder CO-Gruppe an einen Aromaten gebunden sind.

10. Gemisch nach Anspruch 9, dadurch gekennzeichnet, daß als Komponente (III) N(4-Azidosulfonylphenyl)maleinimid eingesetzt wird.

11. Gemisch nach einem der vorhergehenden Ansprüche, dadurch gekennzeichnet, daß es zusätzlich eine

von Komponente (II) verschiedene ethylenisch ungesättigte copolymerisierbare organische Verbindung sowie gegebenenfalls weitere Hilfs- oder Zusatzstoffe enthält.

12. Gemisch nach einem der vorhergehenden Ansprüche, dadurch gekennzeichnet, daß als Komponente (I) Polyamidsäuren der allgemeinen Struktur gemäß Anspruch 2 eingesetzt werden, worin
Ar[1] ausgewählt ist aus den vierwertigen Gruppierungen

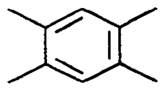 , 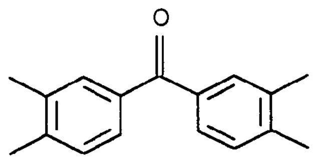 , 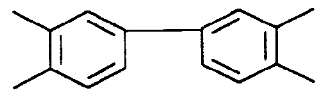

und

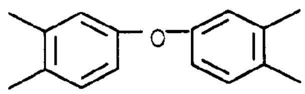

und Ar[2] ausgewählt ist aus den zweiwertigen Gruppierungen

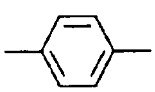 , 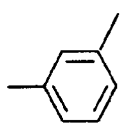 , 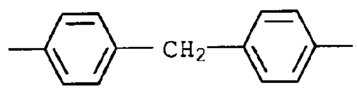 , 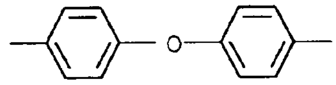

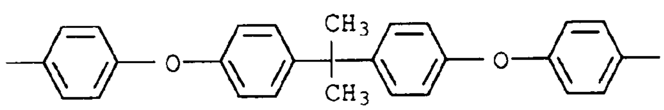

und

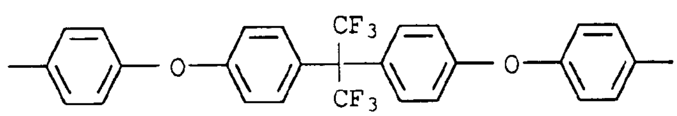 .

13. Gemisch nach Anspruch 5, dadurch gekennzeichnet, daß das Säureanion ausgewählt ist aus der Gruppe Monomaleat, Monooxalat, Propiolat, Methansulfonat und Benzolsulfonat.

14. Verfahren zur Herstellung von hochtemperaturbeständigen Reliefstrukturen durch bildmäßige Bestrahlung von auf einem Träger angebrachten Schichten strahlungsempfindlicher Gemische und Entfernung der unbestrahlten Bereiche dieser Schichten, dadurch gekennzeichnet, daß die Schichten strahlungsempfindlicher Gemische aus Gemischen gemäß einem der vorhergehenden Ansprüche bestehen.

## Claims

1. A radiation-crosslinkable mixture which consists essentially of
(I) at least one carboxyl-containing polymeric precursor of a heterocyclic polymer stable at high temperatures, which precursor is soluble in polar organic solvents,

(II) at least one copolymerizable ethylenically unsaturated ternary sulfonium salt,
(III) at least one photoinitiator or photoinitiator system and
(IV) at least one polar aprotic organic solvent.

2. A mixture as claimed in claim 1, which contains, as component (I), a polyamic acid of the structure

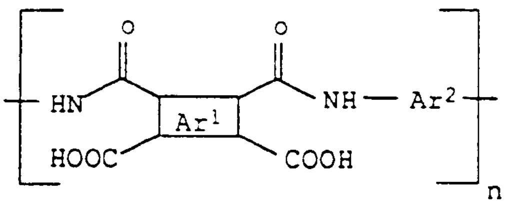

where the carboxyl groups are bonded to $Ar^1$ so that they are ortho or peri to the amido groups, $Ar^1$ is a substituted or unsubstituted tetravalent aromatic, araliphatic, alicyclic, aliphatic or heterocyclic radical and $Ar^2$ is a substituted or unsubstituted divalent aromatic, araliphatic, alicyclic, aliphatic or heterocyclic radical.

3. A mixture as claimed in claim 2, wherein the polyamic acid is a random copolymer or block copolymer, at least two different groups $Ar^1$ and/or $Ar^2$ being present in the polyamic acid.

4. A mixture as claimed in any of the preceding claims, wherein the polyamic acid which carries ethylenically unsaturated terminal groups is used as component (I).

5. A mixture as claimed in any of the preceding claims, which contains, as component (II), a reaction product of thiodiglycol with glycidyl (meth)acrylate and an organic mono-, di- or polycarboxylic acid.

6. A mixture as claimed in any of the preceding claims, wherein a ternary sulfonium salt which contains at least one ethylenically unsaturated group both in the anion and in the cation is used as component (II).

7. A mixture as claimed in any of the preceding claims, wherein the ethylenically unsaturated groups present in component (II) are acrylate or methacrylate groups.

8. A mixture as claimed in any of the preceding claims, wherein an azide is used as component (III).

9. A mixture as claimed in claim 8, wherein an azide which is bonded to an aromatic via an $SO_2$ or CO group is used as component (III).

10. A mixture as claimed in claim 9, wherein N-(4-azidosulfonylphenyl)-maleimide is used as component (III).

11. A mixture as claimed in any of the preceding claims, which additionally contains an ethylenically unsaturated copolymerizable organic compound which differs from component (II) and, if required, further assistants or additives.

12. A mixture as claimed in any of the preceding claims, wherein a polyamic acid of the structure as claimed in claim 2, where
$Ar^1$ is selected from the tetravalent groups

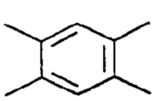 , 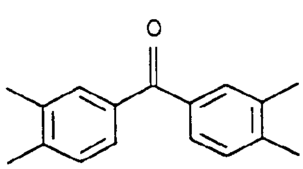 , 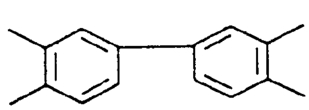

and

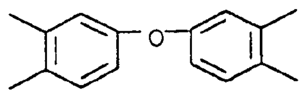

and $Ar^2$ is selected from the divalent groups

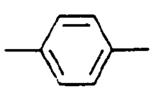 , 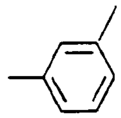 , 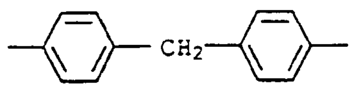 , 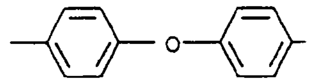

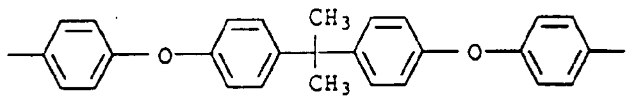

and

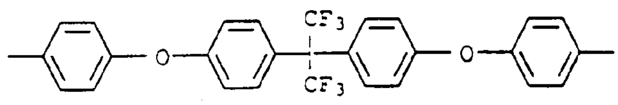 .

is used as component (I).

13. A mixture as claimed in claim 5, wherein the anion is selected from the group consisting of monomaleate, monooxalate, propiolate, methanesulfonate and benzenesulfonate.

14. A process for the production of a relief structure which is stable at high temperatures, by imagewise exposure of a layer of a radiation-sensitive mixture applied to a substrate and removal of the unexposed parts of this layer, wherein the layer of the radiation-sensitive mixture consists of a mixture as claimed in any of the preceding claims.

**Revendications**

1. Mélange réticulant par l'action de radiations qui consiste essentiellement en
   (I) au moins un premier stade polymère à groupes carboxyle soluble dans les solvants organiques polaires, de polymère hétérocyclique résistant aux hautes températures,
   (II) au moins un sel de sulfonium ternaire insaturé éthyléniquement, copolymérisable,
   (III) au moins un photoinitiateur ou système de photoinitiateur et
   (IV) au moins un solvant organique aprotique polaire.

2. Mélange selon la revendication 1, caractérisé par le fait qu'il contient comme composant (I) un polyamide de la structure générale

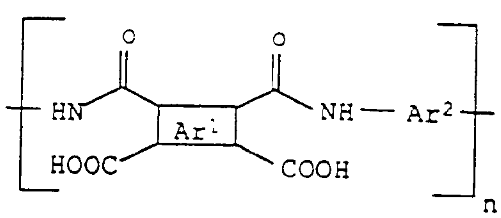

les groupes carboxyle étant liés à $Ar^1$ de manière qu'ils se trouvent en position ortho ou péri par rapport aux groupes amido

Ar[1] étant un reste, substitué ou non substitué, tétravalent aromatique, araliphatique, alicyclique, aliphatique ou hétérocyclique,
Ar[2] étant un reste non substitué ou substitué bivalent aromatique, aralyphatique, alicyclique, aliphatique ou hétérocyclique.

3. Mélange selon la revendication 2, caractérisé par le fait que le polyamide représente un copolymère ou copolymère en bloc statistique, au moins 2 groupes Ar[1]- et/ou Ar[2] différents étant contenus dans le polyamide.

4. Mélange selon l'une des revendications précédentes, caractérisé par le fait que comme composants (I) sont introduits des polyamides qui portent des groupes d'extrémité insaturés éthyléniquement.

5. Mélange selon l'une des revendications précédentes, caractérisé par le fait qu'il contient comme composant (II) un produit de réaction de thiodiglycol avec du (méth)acrylate de glycidyle et d'un mono- ou di- ou polyacide carboxylique organique.

6. Mélange selon l'une des revendications précédentes, caractérisé par le fait que comme composant (II) est introduit un sel de sulfonium ternaire qui contient, aussi bien à l'anion qu'au cation, au moins un groupe insaturé éthyléniquement.

7. Mélange selon l'une des revendications précédentes, caractérisé par le fait que, comme groupes insaturés éthyléniquement contenus dans les composants (II), il s'agit de groupes acrylate ou méthacrylate.

8. Mélange selon l'une des revendications précédentes, caractérisé par le fait que comme composant (III) est introduit un azide.

9. Mélange selon la revendication 8, caractérisé par le fait que comme composants (III) sont introduits des azides qui sont liés à un aromate par un groupe $SO_2$ ou CO.

10. Mélange selon la revendication 9, caractérisé par le fait que comme composant (III) est introduit du N-(4-azidosulfonylphényl)maléinimide.

11. Mélange selon l'une des revendications précédentes, caractérisé par le fait qu'il contient additionnellement un composé organique copolymérisable insaturé éthyléniquement, différent du composant (II).

12. Mélange selon l'une des revendications précédentes, caractérisé par le fait que comme composants (II) sont introduits des polyamides de la structure générale selon la revendication 2, où Ar[1] est choisi parmi les groupements tétravalents.

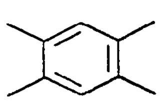 , 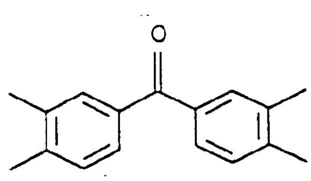 , 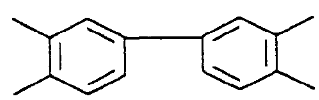

et

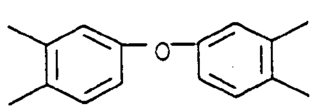

et Ar[2] est choisi parmi les groupements bivalents

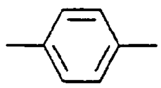 , 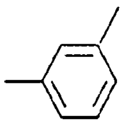 , 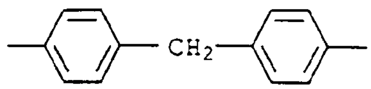 , 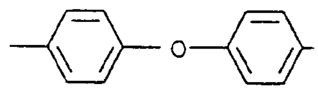

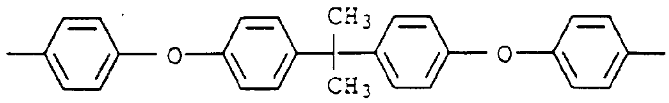

et

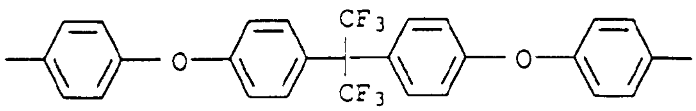 .

**13.** Mélange selon la revendication 5, caractérisé par le fait que l'anion d'acide est choisi parmi les groupes monomaléate, monoxalate, propiolate, méthanesulfonate et benzènesulfonate.

**14.** Procédé de préparation de structures en relief résistant aux hautes températures par irradiation, selon une image, de couches appliquées sur un support, de mélanges sensibles aux radiations et enlèvement des zones de ces couches irradiées, caractérisé par le fait que les couches sont constituées de mélanges sensibles aux radiations selon une des revendications précédentes.